# EUROPEAN PATENT SPECIFICATION

(11) **EP 2 460 182 B1**
(45) Date of publication and mention of the grant of the patent: **13.01.2016**
(21) Application number: 10804946.1
(22) Date of filing: 27.07.2010
(51) Int. Cl.: H01L 35/18, H01L 35/32, C01G 51/00

(54) **A COATING FOR THERMOELECTRIC MATERIALS AND A DEVICE CONTAINING THE SAME**
BESCHICHTUNG FÜR THERMOELEKTRISCHE MATERIALIEN UND VORRICHTUNG DAMIT
REVÊTEMENT DE MATÉRIAUX THERMOÉLECTRIQUES ET DISPOSITIF LE CONTENANT

(30) Priority: 27.07.2009 CN 200910055439
(43) Date of publication of application: 06.06.2012
(73) Proprietor: Shanghai Institute of Ceramics, Chinese Academy of Sciences, Shanghai, 200050 (CN)
(72) Inventor: CHEN, Lidong, Shanghai 200050 (CN); HE, Lin, Corning NY 14830 (US); HUANG, Xiangyang, Shanghai 200050 (CN); LI, Xiaoya, Shanghai 200050 (CN); XIA, Xugui, Shanghai 200050 (CN)
(74) Representative: Kingsbury, Oliver William
(86) International application number: PCT/US2010/043317
(87) International publication number: WO 2011/014479

(56) References cited:
- WO-A1-2009/001598
- WO-A1-2010/115776
- JP-A- H07 106 642
- JP-A- 2009 065 046
- US-A- 3 806 362
- US-A- 5 100 486
- US-A1- 2006 017 170
- US-A1- 2006 076 046
- US-A1- 2008 087 314
- US-A1- 2008 289 677
- US-B1- 6 297 440
- US-B1- 7 480 984
- US-B2- 6 776 622
- SABER ET AL: "Tests results of skutterudite based thermoelectric unicouples", ENERGY CONVERSION AND MANAGEMENT, ELSEVIER SCIENCE PUBLISHERS, OXFORD, GB, vol. 48, no. 2, 1 February 2007 (2007-02-01), pages 555-567, XP022109822, ISSN: 0196-8904, DOI: 10.1016/J.ENCONMAN.2006.06.008
- AMANO T ET AL: "COMMERCIAL ZRO2 PAINTS AS COATINGS FOR SIGE THERMOELECTRIC MATERIALS", JOURNAL OF MATERIALS SCIENCE, KLUWER ACADEMIC PUBLISHERS, DORDRECHT, vol. 24, no. 11, 1 November 1989 (1989-11-01), pages 3831-3836, XP000100836, ISSN: 0022-2461, DOI: 10.1007/BF01168943

## Description

### Technical Field

Disclosed herein is a thermoelectric material coating as well as the structure and the fabricating process of an element (or device) comprising the material in the field of thermoelectric materials and devices.

### Background

Thermoelectric power generation is a power generation technology which takes advantage of the Seebeck effect of semiconducting thermoelectric materials to accomplish direct conversion of thermal energy (temperature difference) to electric energy. A thermoelectric power generation system has a compact structure, reliable performance and superior mobility. In addition, it does not suffer from any noise, abrasion or leakage in operation for it has no operational elements. As an environmentally friendly energy technology, thermoelectric power generation is suitable for recycling energy of low density, and thus wide applications thereof may be envisaged for recycling residual heat from industry and waste heat from car tail gas. Thermoelectric conversion efficiency is mainly determined by the dimensionless performance index of the materials: ZT=S²σT/κ, wherein S represents Seebeck coefficient, σ represents electric conductivity, κ represents thermal conductivity, and T represents absolute temperature. A higher ZT value of the materials means a higher thermoelectric conversion efficiency.

Owing to large crystal cells, heavy atomic mass, large carrier mobility and disturbance of filled atoms in Sb dodecahedron, thermoelectric materials of CoSb₃ based skutterudite exhibit superior high temperature thermoelectric properties at 500-850K, wherein the ZT maxima of n-type Yb_{y}Co₄Sb₁₂ (800K) and p-type CaₓCe_{y}Co_{2.5}Fe_{1.5}Sb₁₂ (750K) are 1.4 and 1.2 respectively. Regarding comprehensive properties, price, safety and fabricating processes, CoSb₃ based skutterudite, among the plurality of new thermoelectric material systems, is the most promising medium to high temperature thermoelectric material for commercial use, and is expected to replace PbTe thermoelectric materials in popular use currently.

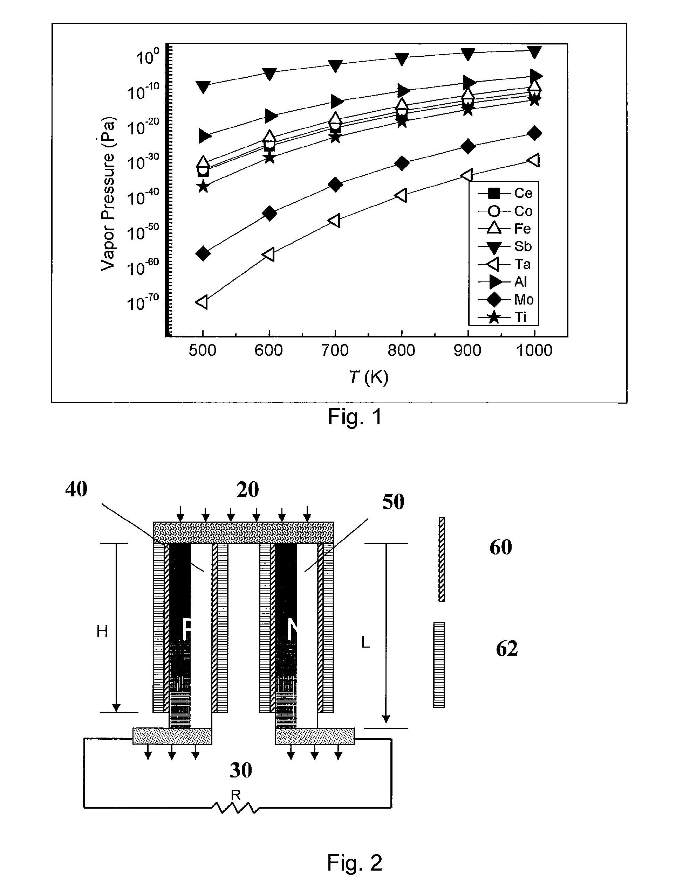

Since the optimal thermoelectric properties of CoSb₃ based skutterudite thermoelectric materials are achieved at 500-850K, the operation temperature of the thermoelectric elements adjacent to the high temperature end in a CoSb₃ based skutterudite thermoelectric device may be up to 850K. The vapor pressure of element Sb is very high at high temperatures (Fig. 1), for example, about 10 Pa at 850K, 12 orders of magnitude higher than those of elements Fe, Co, Ce and the like (David R. Lide, CRC Handbook of Chemistry and Physics, CRC Press, 2005), leading to serious degradation of the properties of the thermoelectric device due to the loss of element Sb at high temperatures.

The surface of a thermoelectric material has to be encapsulated by coating to avoid degradation of the device properties due to evaporation of the material during high temperature operation. Such a measure of coating protection of thermoelectric materials in an operational environment of high temperature may be dated back to more earlier SiGe thermoelectric materials. The high temperature end of a SiGe thermoelectric device may reach a temperature of 1273K. SiGe thermoelectric materials may be protected properly by applying a Si₃N₄ coating having a thickness of millimeters (Kelly C. E. Proceedings of the 10th intersociety energy conversion engineering conference, American Institute of Chemical Engineers, New York 1975, P. 880-6). In an attempt to solve the problem of high temperature evaporation of Sb in CoSb₃ based skutterudite thermoelectric materials, a method of applying a metal coating on the surface of a skutterudite material is proposed by Mohamed (Mohamed S. El-Genk et. al. Energy Conversion and Management, 47 (2006) 174; Hamed H. Saber, Energy Conversion and Management, 48 (2007) 1383). Metal elements suggested for use in the coating for a segment device (p-type element: CeFe_{3.5}Co_{0.5}Sb₁₂ + Bi_{0.4}Sb_{1.6}Te₃, n-type element: CoSb₃ + Bi₂Te_{2.95}Se_{0.05}) include Ta, Ti, Mo and V. The thickness of a metal coating is supposed to be 1-10µm. According to theoretical deduction, the higher the electric conductivity of a metal coating or the larger the thickness of the coating, the higher the peak output power, but the lower the peak conversion efficiency. Neither the process for preparing coatings nor the comparison between the experimental data of the four coatings is mentioned in the paper of Mohamed.

Though the method proposed by Mohamed to apply a metal coating on the surface of a CoSb₃ based skutterudite material having specific components indicates a direction to solve the problem of evaporation of Sb at high temperatures, the scope covered by the method is rather narrow, and the problem of high temperature oxidation in the practical environment confronted by the CoSb₃ based skutterudite material and the elements comprising the material has not been solved.

Earlier filed international application WO2010/115776 A1, published 14.10.2010, discloses a thermoelectric material coated with an inner protective metal layer and an outer layer containing ceramic.

Therefore, there is an urgent need in the art for a coating, which may be used for a thermoelectric material and may solve the problem of high temperature oxidation, as well as a device comprising the material.

### Summary

According to a first embodiment, a coating may be used for a thermoelectric material and may solve the problem of high temperature oxidation. According to a second embodiment, a device is disclosed which comprises the material and may solve the problem of high temperature oxidation. In yet a further embodiment, a fabricating process for forming the thermoelectric material is disclosed, and may solve the problem of high temperature oxidation.

Disclosed herein is a coated thermoelectric material, comprising a thermoelectric layer comprising a thermoelectric material selected from a filled and/or doped CoSb₃ based skutterudite, a metal coating of one or more layers forming a surface in contact with said thermoelectric layer and an opposing surface, and a metal oxide coating of one or more layers comprising metal oxides, wherein said metal oxide coating forms a surface in contact with said opposing surface.

In a specific embodiment, the metal coating(s) comprises Ta, Nb, Ti, Mo, V, A1, Zr, Ni, NiAl, TiAl, NiCr or a combination thereof.

In a specific embodiment, the metal oxide coating(s) comprises TiO₂ Ta₂O₅, Nb₂O₅, Al₂O₃, ZrO₂, NiO, SiO₂ or a combination thereof.

In a specific embodiment, the coating has a thickness of 10-500µm, for example 50-200µm.

In a specific embodiment, the metal coating(s) has a thickness of 0.01-20µm (microns), for example, 0.2-2µm (microns).

In a specific embodiment, the thermoelectric layer has a height of L_{T}, and the metal coating(s) the said metal oxide coating(s) each has a height of L_{M&MOx}, wherein L_{M&MOx}≤L_{T}, and (L_{T} -L_{M&MOx})/ L_{T}≤0.4.

In a further embodiment, there is disclosed a device comprising the coating.

In a still further embodiment, a process for fabricating the coating comprises providing a thermoelectric layer comprising a thermoelectric material, forming a metal coating of one or more layers on said thermoelectric layer, wherein said metal coatings forms a surface in contact with the thermoelectric layer as well as an opposing surface, and forming a metal oxide coating of one or more layers on said metal coating(s), wherein said metal oxide coatings comprise metal oxides and form a surface in contact with said opposing surface of said metal coating(s).

In some embodiments, all or a portion of said metal coatings are formed by thermal evaporation, arc spraying, plasma spraying, flame spraying, vacuum sputtering, electrochemical vapor deposition, electric plating or electroless deposition.

In some embodiments, all or a portion of said metal oxide coatings are formed by thermal evaporation, vacuum sputtering, plasma spraying, sol-gel, chemical solution deposition or chemical vapor deposition.

In some embodiments, at least part of said metal coating is oxidized to contact said metal oxide coating with said opposing surface of said metal coating.

### Brief Description of the Drawings

Fig. 1 shows the high temperature vapor pressures of some elements;
Fig. 2 shows a π-type device of CoSb₃ based skutterudite having multiple coatings;
Fig. 3 shows the top-view cross section of the thermoelectric element covered by multiple encapsulations according to Fig. 2 (left: circular, right: square); and
Fig. 4 shows the SEM image of the interface between the Yb_{0.3}Co₄Sb₁₂ core and the encapsulation.

### Detailed Description

After extensive and intensive study, the present inventors have solved both problems of Sb evaporation and material oxidation at high temperatures as mentioned above and have improved both durability and reliability of CoSb₃ based skutterudite materials and devices made therefrom by modifying the fabricating processes to form two classes of multiple coatings, namely metal and metal oxide coatings, on the surface of a thermoelectric material (typically a CoSb₃ based skutterudite material) using physical and chemical means.

For application requirements of a thermoelectric material and an element made therefrom, two classes of multiple coatings, namely metal and metal oxide coatings, are formed on the surface of the CoSb₃ based skutterudite material or the element using a physical or chemical coating forming process to prevent Sb from evaporation and material oxidation at high operation temperatures.

Disclosed is a process for fabricating a thermoelectric material having a structure of multiple coatings as well as an element thereof in the field of thermoelectric materials and devices. The composition of the material may be described as SKT/M/MOₓ, wherein SKT includes CoSb₃ based skutterudite compounds, doped CoSb₃ based skutterudite compounds, CoSb₃ based filled skutterudite compounds, doped CoSb₃ based filled skutterudite compounds, M represents a metal coating, including but not limited to one of Ta, Nb, Ti, Mo, V, Al, Zr, Ni, NiAl, TiAl, NiCr or an alloy of two or more of them, and MOₓ represents a metal oxide coating, including but not limited to one of TiO₂, Ta₂O₅, Nb₂O₅, Al₂O₃, ZrO₂, NiO, SiO₂, or a composite of two or more of them, or a multi-layer structure of two or more of them. The material or element as represented by SKT/M/MOₓ has a concentric structure of multiple encapsulations.

In other words, the SKT material is encapsulated at its surface by a layer of metal M, and the M layer is further encapsulated at its surface by one or more layers of MOₓ. The encapsulations function to prevent Sb in SKT from evaporation and SKT material from oxidation. The main role of the metal M layer lies in the improvement of compactness, consistency and binding strength of the MOₓ encapsulation. The processes for fabricating encapsulations include thermal evaporation, physical sputtering, arc spraying, plasma thermal spraying, electrochemical vapor deposition, chemical vapor deposition, solution chemical vapor deposition, pulse electric deposition and the like. The total thickness of the coatings is typically 10-500µm, wherein the thickness of the M layer 0.01-20µm, and that of the MOₓ layer is 9.99-499.9µm.

The process can be used to fabricate a CoSb₃ based skutterudite material having a concentric multi-layer structure which is effective in avoiding Sb evaporation and SKT oxidation at high temperatures. As indicated by the results of high temperature aging, the conversion efficiency of an encapsulated π-type element remains substantially unchanged after 1000 hours of high temperature aging test, while that of the unencapsulated version of the same π-type element decreases by 70% after 1000 hours of aging. The disclosed approach has remarkably enhanced the durability of the CoSb₃ based skutterudite material and the device made therefrom, which may work for an extended time at a temperature ranging from room temperature to 600°C as a practical thermoelectric material and a practical device respectively.

As used herein, "opposing" means that two elements involved are facing each other in terms of position relationship.

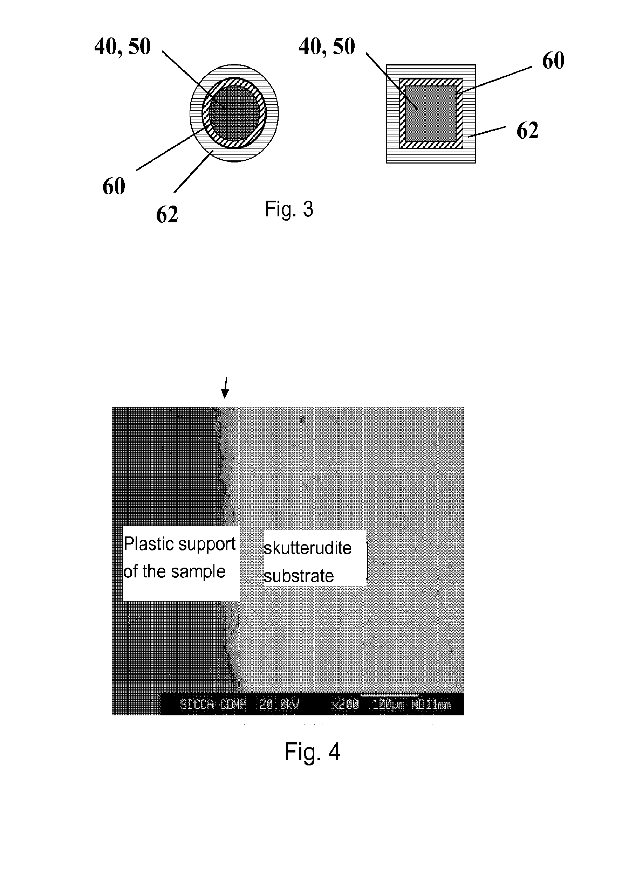

Figs. 2 and 3 show an element and coatings thereof having a coated concentric multi-layer structure, wherein the general formula of the structure may be described as SKT/M/MOₓ, i.e., a structure of thermoelectric material (SKT)/coatings (M/MOₓ). In Fig. 2 a heat source 20 is separated from a heat sink 30 by a p-type element 40 and an n-type element 50. The height of the elements is L. Formed over each element is a metal coating 60 and a metal oxide coating 62. The height of the metal and metal oxide coatings is H. Fig. 3 shows example cross-sectional elements 40,50 having a Mo metal coating 60 and a ZrO2 oxide coating 62.

SKT may be selected from CoSb₃ based skutterudite materials, doped CoSb₃ based skutterudite compounds, CoSb₃ based filled skutterudite compounds, doped CoSb₃ based filled skutterudite compounds and composite materials with the foregoing compounds as the dominant phase; as well as thermoelectric materials of cage-type compounds, semi-Heusler thermoelectric materials, BiTe based materials, doped BiTe based compounds, BiTe based filled compounds, doped BiTe based filled compounds and composite materials with the foregoing compounds as the dominant phase. Preferably, SKT is selected from CoSb₃ based skutterudite materials, doped CoSb₃ based skutterudite compounds, CoSb₃ based filled skutterudite compounds, doped CoSb₃ based filled skutterudite compounds and composite materials with the foregoing compounds as the dominant phase.

The metal coating M is a thin film coating of a metal or an alloy, including but not limited to one of Ta, Nb, Ti, Mo, V, Al, Zr, Ni, NiAl, TiAl, NiCr or an alloy of two or more of them.

MOₓ is a coating of a metal oxide, including but not limited to one of TiO₂, Ta₂O₅, Nb₂O₅, Al₂O₃, ZrO₂ NiO, SiO₂, or a composite of two or more of them, or a multi-layer structure of two or more of them.

The disclosure provides a process for fabricating a CoSb₃ based skutterudite compound material having multiple coatings and a device made therefrom. The core of the process is the formation of one or more outer oxide layers having strong adhesion, high compactness and good consistency, and the formation of one or more inner metal layers, by a physical or chemical means. The transitional layer of a metal can prevent element Sb from evaporation at high temperatures and enhance the binding strength between the oxide layer and the skutterudite material.

All or a portion of the metal coatings may be formed by thermal evaporation, arc spraying, plasma spraying, flame spraying, vacuum sputtering, electrochemical vapor deposition, electric plating or electroless deposition.

All or a portion of the metal oxide coatings are formed by thermal evaporation, vacuum sputtering, plasma spraying, sol-gel, chemical solution deposition or chemical vapor deposition.

In some embodiments, a filled and/or doped CoSb₃ based skutterudite compound material or element is used as the core, and a process of thermal evaporation, physical sputtering, arc spraying, pulse electric deposition, electrochemical deposition or electric plating among others is used to form one or more transitional layers of M on the surface of the skutterudite material. Then, one or more oxide layers of MOₓ are formed on the surface of the M layer by a process of thermal evaporation, physical sputtering, plasma thermal spraying, sol-gel, chemical solution deposition or chemical vapor deposition among others. With respect to those metal elements which are susceptible to oxidation, a MOₓ layer may also be obtained by direct oxidation of a M layer at an appropriate partial pressure of oxygen, wherein the partial pressure of oxygen and the temperature thereof are the key process parameters for controlling thickness.

Among the two classes of coatings, the inner M transitional coating, having a smaller thickness of 0.01-20µm, mainly functions to enhance the binding strength of the MOₓ coating. The total thickness of the M layer is determined by the core of the skutterudite material, the components, thermal conductivity and electric conductivity of the M layer itself, the process for forming the M layer, the components of the MOₓ layer, and the like. An approach to controlling the thickness of the M layer is the prevention of any bypass for rapid heat flow and current flow from being formed. The outer preventive coating of MOₓ has a larger thickness which is determined by the components of the material, the process for forming the MOₓ layer, the compactness and thermal conductivity of the MOₓ layer, and the like. The total thickness of the two classes of coatings is 10-500µm.

If a CoSb₃ based skutterudite material with multiple encapsulations is used as a thermoelectric element to form a device, the length (height) of the outer coating of the element should be less than or equal to the length (height) of the element. If it is less than the length (height) of the element, the element may have an area near the low temperature end that has a length not greater than 40% of the total length of the element and is left uncoated. The length (height) of the coating is determined by the length (height) of the element, the temperature of the high temperature end, the thickness of the coating, particularly of the M transitional layer, and the thermal properties of the skutterudite element core. In the case of a π-type device, if the coating length on the element surface is less than that of the element, the coatings on the p-type and n-type elements may have different lengths on condition that the operation temperatures of the uncoated parts of the two elements are close to each other.

A π-type device prepared according to the present disclosure has substantially improved durability and reliability during continuous use in high temperature environment. Despite slight decrease in thermoelectric conversion efficiency and electric power in comparison with a device constructed with an uncoated material, the device constituted by a coated material suffers from little degradation of properties after long-term (1000 hours) operation at high temperature (850K) in contrast to about 70% of decrease in thermoelectric conversion efficiency suffered by a device without coating protection after long-term operation at high temperature.

The high temperature evaporation of element Sb in the SKU material and the oxidation of SKU can be prevented effectively by the coating material. The main functions of the M layer include: (i) preventing element Sb from evaporation at high temperatures; and (ii) enhancing adhesion, compactness, consistency and binding strength of the MOₓ layer.

Unless otherwise specified, the various starting materials in the disclosure may be commercially available or prepared by any conventional method known in the art. Unless otherwise defined or specified, all special and scientific terms used herein have the meanings known by those skilled in the art.

The invention will be explained in further detail with reference to the following specific examples. It is to be understood that these examples are provided only for the purpose of illustrating the invention without limiting the scope thereof. Generally, in the following examples, conventional conditions, or those suggested by manufacturers, will be followed where no specific conditions are given for an experiment. Unless otherwise specified, all ratios and percentages are based on weight, and polymeric molecular weights are number average molecular weights.

Unless otherwise defined or specified, all special and scientific terms used herein have the meanings known by those skilled in the art. In addition, any process or material similar or equivalent to those cited herein may be used in the invention.

### Example 1

A CoSb₃ based filled n-type skutterudite material, having a nominal composition of Ba_{0.24}Co₄Sb₁₂, was sintered into a block material which was then processed into a cuboid-shaped sample measuring 3×3×15 mm³. A NiCrMo coating (Ni:Cr:Mo = 68:24:8) having a thickness of about 5µm was formed on the surface of the sample by arc spraying, wherein the process parameters of the arc spraying include: arc voltage 28-30V, operation current 180-200A, gas pressure 0.4-0.6 MPa, spraying distance 150-200mm. Subsequently, a SiO₂ coating having a thickness of about 60µm was formed on the NiCrMo coating by plasma spraying, wherein the process parameters of the plasma spraying include: spraying distance 70-100mm, powder delivery rate 0.5-1g/min, spraying current 70-100A, ion gas Ar flow rate 1-1.5L/min, powder delivery gas Ar flow rate 1-3L/min.

### Example 2

A CoSb₃ based filled n-type skutterudite material, having a nominal composition of Ba_{0.18}Ce_{0.06}Co₄Sb₁₂, was sintered into a block material which was then processed into a cuboid-shaped sample measuring 3x3x15 mm³. An Al coating having a thickness of about 2µm was formed on the surface of the sample by magnetron sputtering, wherein the Al target had a diameter of 75mm and a thickness of 5mm, and the sputtering gas was pure argon (with a purity of 99.999%) which had a flow rate of 15mL/min. During the film sputtering, the background vacuum was 10Pa, and the operation pressure was 0.2Pa. In addition, the temperature of the sample was ambient temperature (20°C), the sputtering power was 40W, and the deposition rate of the thin film was about 12nm/min. Finally, the sample with an aluminum coating was oxidized for 1 hour in air at 150°C to form an Al₂O₃ coating on its surface.

### Example 3

This example was a π-type device composed of CoSb₃ based filled skutterudite elements having a multiple of concentric encapsulations. The p-type element and the n-type element have nominal compositions of Ce_{0.9}Co_{2.5}Fe_{1.5}Sb₁₂ and Yb_{0.3}Co₄Sb₁₂ respectively. The sintered block material was processed into a cuboid-shaped sample measuring 3x3x15 mm³. The p-type element and the n-type element were first covered at one end (including end face) with carbon paper for about 3.5mm and 5.5mm respectively, while the other ends were covered at the end face with the same material. The exposed surface of each of the two elements was sprayed with a Mo coating of about 6µm thick by arc spraying, and then a ZrO₂ coating of about 20µm thick was sprayed on the Mo coating by plasma spraying. Finally, the carbon paper was removed, and a p-type element and an n-type element having a coating length of 16.5mm and 14.5mm respectively were obtained (see Fig. 4).

## Claims

1. A coated thermoelectric material comprising
a thermoelectric layer (40,50) comprising a thermoelectric material selected from a filled and/or doped CoSb₃ based skutterudite;
a metal coating (60) of one or more layers, wherein the metal coating forms a surface in contact with said thermoelectric layer and as well as an opposing surface;
**characterised by** a metal oxide coating (62) of one or more layers, comprising metal oxides, wherein said metal oxide coating forms a surface in contact with said opposing surface.

2. The coated thermoelectric material of claim 1, wherein said metal coating(s) comprises Ta, Nb, Ti, Mo, V, Al, Zr, Ni, NiAl, TiAl, NiCr or a combination thereof.

3. The coated thermoelectric material of claim 1, wherein said metal oxide coating(s) comprises TiO₂, Ta₂O₅, Nb₂O₅, Al₂O₃, ZrO₂, NiO, SiO₂ or a combination thereof.

4. The coated thermoelectric material of claim 1, wherein the coating has a thickness of 10-500 µm.

5. The coated thermoelectric material of claim 4, wherein the coating has a thickness of 50-200 µm.

6. The coated thermoelectric material of claim 1, wherein said metal coating(s) has a thickness of 0.01-20 µm.

7. The coated thermoelectric material of claim 6, wherein said metal coating(s) has a thickness of 0.2-2µm.

8. The coated thermoelectric material of claim 1, wherein said thermoelectric layer has a height of L_{T}, and said metal coating(s) and said metal oxide coating(s) each has a height of L_{M&MOx}, wherein L_{M&MOx}≤L_{T}, and (L_{T} L_{M&MOx})/ L_{T}≤0.4.

9. A device comprising the coated thermoelectric material of claim 1.

10. A process for fabricating the coated thermoelectric material of claim 1, comprising
providing a thermoelectric layer (40,50) comprising a thermoelectric material;
forming a metal coating (60) of one or more layers on said thermoelectric layer, wherein said metal coatings forms a surface in contact with said thermoelectric layer as well as an opposing surface;
forming a metal oxide (62) coating of one or more layers comprising a metal oxide on said metal coating(s), wherein said metal oxide coatings form a surface in contact with said opposing surface of said metal coating(s).

11. The process of claim 10, comprising
forming all or a portion of said metal coatings by thermal evaporation, arc spraying, plasma spraying, flame spraying, vacuum sputtering, electrochemical vapor deposition, electric plating or electroless deposition.

12. The process of claim 10, comprising
forming all or a portion of said metal oxide coatings by thermal evaporation, vacuum sputtering, plasma spraying, sol-gel, chemical solution deposition or chemical vapor deposition.

13. The process of claim 10, comprising
at least partially oxidizing said metal coating, to form said metal oxide coating in contact with said opposing surface of said metal coating.

## Patentansprüche

1. Ein beschichtetes thermoelektrisches Material, beinhaltend
eine thermoelektrische Schicht (40, 50),
beinhaltend ein thermoelektrisches Material, ausgewählt aus einem gefüllten und/oder dotierten CoSb₃-basierten Skutterudit;
eine Metallbeschichtung (60) aus einer oder mehreren Schichten, wobei die Metallbeschichtung eine Oberfläche, die mit der thermoelektrischen Schicht in Kontakt ist, sowie eine entgegengesetzte Oberfläche bildet;
**gekennzeichnet durch** eine Metalloxidbeschichtung (62) aus einer oder mehreren Schichten, beinhaltend Metalloxide, wobei die Metalloxidbeschichtung eine Oberfläche, die mit der entgegengesetzten Oberfläche in Kontakt ist, bildet.

2. Das beschichtete thermoelektrische Material gemäß Anspruch 1, wobei die Metallbeschichtung(en) Ta, Nb, Ti, Mo, V, Al, Zr, Ni, NiAl, TiAl, NiCr oder eine Kombination davon beinhalten.

3. Das beschichtete thermoelektrische Material gemäß Anspruch 1, wobei die Metalloxidbeschichtung(en) TiO₂, Ta₂O₅, Nb₂O₅, Al₂O₃, ZrO₂, NiO, SiO₂ oder eine Kombination davon beinhalten.

4. Das beschichtete thermoelektrische Material gemäß Anspruch 1, wobei die Beschichtung eine Dicke von 10-500 µm aufweist.

5. Das beschichtete thermoelektrische Material gemäß Anspruch 4, wobei die Beschichtung eine Dicke von 50-200 µm aufweist.

6. Das beschichtete thermoelektrische Material gemäß Anspruch 1, wobei die Metallbeschichtung(en) eine Dicke von 0,01-20 µm aufweist.

7. Das beschichtete thermoelektrische Material gemäß Anspruch 6, wobei die Metallbeschichtung(en) eine Dicke von 0,02-2 µm aufweist.

8. Das beschichtete thermoelektrische Material gemäß Anspruch 1, wobei die thermoelektrische Schicht eine Höhe von L_{T} aufweist und die Metallbeschichtung(en) und die Metalloxidbeschichtung(en) jeweils eine Höhe von L_{M&MOX} aufweist, wobei L_{M&MOX}≤L_{T} und (L_{T}-L_{M&MOX})/L_{T}≤0,4 ist.

9. Ein Gerät, beinhaltend das beschichtete thermoelektrische Material gemäß Anspruch 1.

10. Ein Prozess zum Herstellen des beschichteten thermoelektrischen Materials gemäß Anspruch, beinhaltend
Bereitstellen einer thermoelektrischen Schicht (40, 50), beinhaltend ein thermoelektrisches Material;
Bilden einer Metallbeschichtung (60) aus einer oder mehreren Schichten auf der thermoelektrischen Schicht, wobei die Metallbeschichtungen eine Oberfläche, die mit der thermoelektrischen Schicht in Kontakt ist, sowie eine entgegengesetzte Oberfläche bilden; Bilden einer Metalloxidbeschichtung (62) aus einer oder mehreren Schichten, beinhaltend ein Metalloxid auf der (den) Metallbeschichtung(en), wobei die Metalloxidbeschichtungen eine Oberfläche, die mit der entgegengesetzten Oberfläche der Metallbeschichtung(en) in Kontakt ist, bilden.

11. Prozess gemäß Anspruch 10, beinhaltend
Bilden aller oder eines Teils der Metallbeschichtungen durch thermische Verdampfung, Lichtbogenspritzen, Plasmaspritzen, Flammspritzen, Vakuumsputtern, elektrochemische Dampfabscheidung, elektrisches Plattieren oder stromlose Abscheidung.

12. Prozess gemäß Anspruch 10, beinhaltend
Bilden aller oder eines Teils der Metalloxidbeschichtungen durch thermische Verdampfung, Vakuumsputtern, Plasmaspritzen, Sol-Gel, chemische Lösungsabscheidung oder chemische Dampfabscheidung.

13. Prozess gemäß Anspruch 10, beinhaltend mindestens teilweises Oxidieren der Metallbeschichtung, um die Metalloxidbeschichtung, die mit der entgegengesetzten Oberfläche der Metallbeschichtung in Kontakt ist, zu bilden.

## Revendications

1. Matériau thermoélectrique enduit comprenant
une couche thermoélectrique (40, 50) comprenant un matériau thermoélectrique choisi parmi une skuttérudite à base de CoSb₃ dopée et/ou remplie ;
un revêtement métallique (60) constitué d'une ou plusieurs couches, ledit revêtement métallique formant une surface en contact avec ladite couche thermoélectrique et aussi une surface opposée ;
**caractérisé par** un revêtement d'oxyde métallique (62) constitué d'une ou plusieurs couches, comprenant des oxydes métalliques, ledit revêtement d'oxyde métallique formant une surface en contact avec ladite surface opposée.

2. Matériau thermoélectrique enduit selon la revendication 1, ledit ou lesdits revêtements métalliques comprenant du Ta, Nb, Ti, Mo, V, Al, Zr, Ni, NiAl, TiAl, NiCr ou une combinaison de ceux-ci.

3. Matériau thermoélectrique enduit selon la revendication 1, ledit ou lesdits revêtements d'oxyde métallique comprenant du TiO₂, Ta₂O₅, Nb₂O₅, Al₂O₃, ZrO₂, NiO, SiO₂ ou une combinaison de ceux-ci.

4. Matériau thermoélectrique enduit selon la revendication 1, ledit revêtement ayant une épaisseur de 10 à 500 µm.

5. Matériau thermoélectrique enduit selon la revendication 4, ledit revêtement ayant une épaisseur de 50 à 200 µm.

6. Matériau thermoélectrique enduit selon la revendication 1, ledit ou lesdits revêtements métalliques ayant une épaisseur de 0,01 à 20 µm.

7. Matériau thermoélectrique enduit selon la revendication 6, ledit ou lesdits revêtements métalliques ayant une épaisseur de 0,2 à 2 µm.

8. Matériau thermoélectrique enduit selon la revendication 1, ladite couche thermoélectrique ayant une hauteur de L_{T}, et ledit ou lesdits revêtements métalliques et ledit ou lesdits revêtements d'oxyde métallique ayant chacun une hauteur de L_{M&Mox}, dans lequel L_{M&MOx}≤L_{T} et (L_{T}-L_{M&Mox})/L_{T}≤0,4.

9. Dispositif comprenant le matériau thermoélectrique enduit selon la revendication 1.

10. Procédé de fabrication dudit matériau thermoélectrique enduit selon la revendication 1, comprenant
la fourniture d'une couche thermoélectrique (40, 50) comprenant un matériau thermoélectrique ;
la formation d'un revêtement métallique (60) constitué d'une ou plusieurs couches sur ladite couche thermoélectrique, lesdits revêtements métalliques formant une surface en contact avec ladite couche thermoélectrique ainsi qu'avec une surface opposée ;
la formation d'un revêtement d'oxyde métallique (62) constitué d'une ou plusieurs couches comprenant un oxyde métallique sur ledit ou lesdits revêtements métalliques, lesdits revêtements d'oxyde métallique formant une surface en contact avec ladite surface opposée dudit ou desdits revêtements métalliques.

11. Procédé selon la revendication 10, comprenant
la formation de la totalité ou d'une partie desdits revêtements métalliques par évaporation thermique, projection à l'arc électrique, projection au plasma, projection à la flamme, pulvérisation sous vide, dépôt chimique en phase vapeur, électro-placage ou dépôt sans courant.

12. Procédé selon la revendication 10, comprenant
la formation de la totalité ou d'une partie desdits revêtements d'oxyde métallique par évaporation thermique, pulvérisation sous vide, projection au plasma, procédé sol-gel, dépôt chimique en solution ou dépôt chimique en phase vapeur.

13. Procédé selon la revendication 10, comprenant
l'oxydation au moins partielle dudit revêtement métallique, pour former ledit revêtement d'oxyde métallique en contact avec ladite surface opposée dudit revêtement métallique.
